# EUROPEAN PATENT APPLICATION

(11) **EP 3 376 669 A1**
(43) Date of publication of application: **19.09.2018**
(21) Application number: 17305299.4
(22) Date of filing: 17.03.2017
(51) Int. Cl.: H03K 19/177

(54) **FPGA AND METHOD OF FPGA PROGRAMMING**

(71) Applicant: MENTA, 34000 Montpellier (FR)
(72) Inventor: ROUGE, Laurent, 34920 LE CRES (FR); EYDOUX, Julien, 34090 MONTPELLIER (FR)
(74) Representative: Bell, Mark

(57) **Abstract**

A multiple tiered programming structure (38, 41, 37) is provided for the memory cells determining the operation of a FPGA, where a first tier (38) comprising a set of program storage elements (3801-3814), possibly configured in a shift register is loaded with the program, whereby each program storage element passes its value on to a respective coupling device (41, 37) (which may also be a flip flop). The coupling devices are then clocked in synchrony (402, 412) to provide the values to the memory cells. This makes it possible to easily refresh the memory cells. In some embodiments a plurality of sets of coupling devices (37, 41) may be provided, and the memory cell can be loaded with the value from a selected one (3801-3814) of these coupling devices, or indeed directly from the set of program storage elements s. A mechanism (fig. 5: 39) may be provided for reading back from the coupling devices (fig. 5: 37) into the shift register (fig. 5: 38) so as to read out the values (fig. 5: output of Mux3901-3914) of the coupling devices for validation of the FPGA results.

## Description

### Field of the invention

The present invention relates to Programmable Logic Devices (PLD), and more particularly to Field Programmable Gate Array (FPGA) devices.

### Background of the invention

FPGAs are a type of Programmable Logic Device. They are generally based on a standard programmable Logic Block, a large number of which are arranged together to implement various functions.

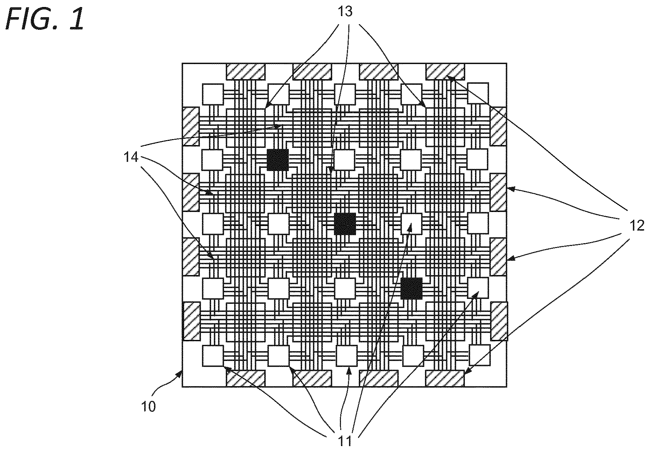

Figure 1 shows schematically an example of an FPGA system as known in the state of the art.

As shown in figure 1, an FPGA chip 10 comprises a number of logic blocks 11, for example as described above. The chip also comprises a number of input/output ports 12. Connecting these logic blocks 11 and input/output ports 12 are a number of tracks 14. At junction points of these tracks are provided and number of programmable routing areas 13, which may also be referred to as switch boxes. In these programmable routing areas there are provided switches which can selectively connect any pair of intersecting tracks, under the control of a logical value stored in a bit cell memory connected with each switch. The bit cell memory values are set at system start up from a non volatile memory. Accordingly, by setting the values in the switch memories as required, any connections of any logic block can be coupled to those of any other logic block, or any input/output port 12. Similarly any one input/output port may be connected to any other input/output port. Thus, by properly configuring the memory units to define the operation of each logic block, and the switch memories 13 to establish appropriate connections between the logic blocks, any desired functionality can be implemented.

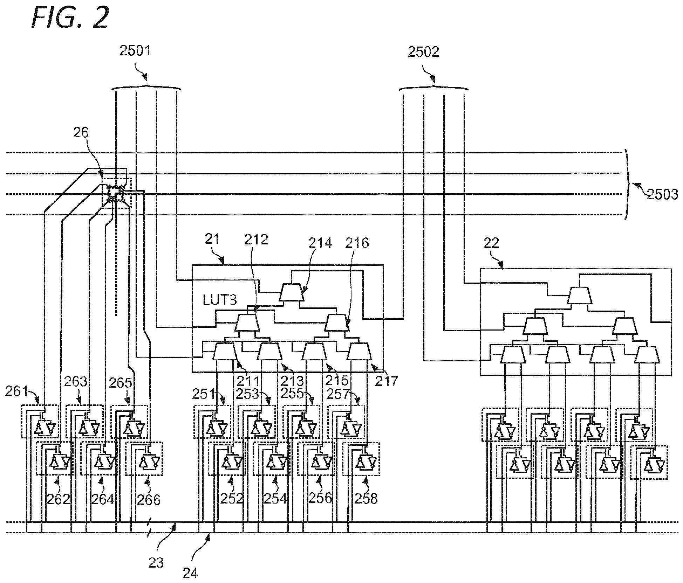

Figure 2 shows further detail of elements of an FPGA system as known in the state of the art.

The elements shown in figure 2 constitute a representative example of a partial implementation of parts of the functionality described above with respect to figure 1.

As shown in figure 2, there is provided a first Look Up Table (LUT) 21, and a second Look Up Table (LUT) 22, and a number of further LUTs (not shown). Each LUT thus corresponds to a logic block 11 as described in figure 1, although in real FPGA implementations each logic block will generally comprise more than one LUT, and possibly other circuits extending or enhancing the functionality of the logic block, such that logic block of different types may be defined with characteristic functionality. The first LUT 21 comprises seven, two input multiplexers 211, 212, 213, 214, 215, 216, 217 respectively. The second LUT and further LUTs are configured similarly. These multiplexers are arranged in a cascading manner with three rows so as to constitute an 8 input multiplexer, the output of which constitutes the output of the LUT. The first row of multiplexers (211, 213, 215 and 217) in each cascade arrangement both have a total of eight inputs. These eight inputs constitute the programming inputs of the first LUT 21. The selection inputs of each row are ganged together, to constitute the three data inputs of the LUT. The data inputs and data output of the first LUT are connected to a set of tracks 2501, 2502. The inputs and outputs of the second and further LUTs are connected correspondingly to a network of further tracks (not shown). Conventionally a LUT with 3 data inputs in this manner is referred to as a "LUT3". This is generally termed the LUT size, and the number of LUTs of each size required to implement a particular operation is a basic element in designing an FPGA to implement that operation. Each of the eight programming inputs of the first LUT 21 is connected to a respective bit cell memory 251, 252, 253, 254, 255, 256, 257, 258. Corresponding bit cells provide the configuration inputs of the second LUT 22, and the other LUTs provided in the system (not shown). In operation, these bit cell memories 251, 252, 253, 254, 255, 256, 257, 258 provide a constant predetermined logical value to each of the eight programming inputs of each LUT. The content of each bit cell memory is shown schematically as comprising a latch built of two inverters, each receiving the output of the other, with a transistor switch, switched by a respective word line, provided to enable the selective output of the value on the output of one of the inverters in the latch to a bit line connected to a respective configuration input of the LUT 217, and also to a respective data line by means of which the value of the latch may be set. The bit line of each bit cell memory 251, 252, 253, 254, 255, 256, 257, 258 is connected to a selection bus 23, and the word line of each bit cell memory 251, 252, 253, 254, 255, 256, 257, 258 is connected to a data bus 24. During an initiation phase for the circuit, each bit cell memory 251, 252, 253, 254, 255, 256, 257, 258 is addressed in turn, and the desired value set to the latch in question. The logical behaviour of the LUT in response to any binary value on its three data inputs can thus be defined as required. This is the underlying basic concept of FPGA technology. It will be appreciated however that the functions that a single logic block comprising two LUT3s can implement are limited, however by interconnecting a number of suitably configured LUTs as described above, any arbitrary combinatorial function can be implemented. This interconnection is achieved through a programmable interconnection of the data channels 2501, 2502, and further channels (not shown) carrying data from other LUTs. As shown whilst channels 2501, 2502 are arranged vertically, there is provided a further channel 2503 intersecting channels 2501, 2502. At the intersection of respective lines of channels 2501 and 2503 is provided a programmable switching unit 26. Considering that the intersection of the two lines constitutes a total of four connections at the switching unit, the switching unit comprises 6 transistor switches, arranged to make or break a connection between any two of these four connections. Each of these transistor switches is set to be open or closed by a value received from a respective bit cell memory 261, 262, 263, 264, 265, 266. Further such programmable switching units, with corresponding bit cell memories are provided at many or all track intersections (not shown). These bit cell memories 261, 262, 263, 264, 265, 266 as shown are identical to the bit cell memories 251, 252, 253, 254, 255, 256, 257, 258, and connected to the same selection bus 23 and data bus 24, so that during an initiation phase for the circuit, both the LUT bit cell memories and switch bit cell memories may be addressed in turn, and the desired value set to the latch in question, so that the behaviour of each LUT, and its connections to any other LUT may be configured as required.

WO2012/123243 A1, US7463056 B1, US6021513 A, US5432441 A, US8091001 B2,US5675589 A, and US5027355 A describe certain aspects of the foregoing.

The article entitled "Bridging the Gap between Soft and Hard eFPGA Design", by Victor Olubunmi Aken'Ova chapter 3.22 available from https://www.ece.ubc.ca/∼lemieux/publications/akenova-masc2005.pdf provides further background information.

While the approach described is highly flexible, it will be appreciated that the interconnection tracks between LUTs and the bit and word lines of the bit cell memories take a significant amount of space. Even in the highly simplified arrangement of figure 2 the number of lines shown is substantial, and this quickly becomes onerous in any real implementation. This is further exacerbated by the need to implement testing functionality in the circuit, provided to confirm proper behaviour when the device is manufactured, which will require the addition of still further features. It is desirable to increase the flexibility of the means for programming these LUT memory devices and switch memory devices. US 6201406 B1 and US 8670520 B2 seek to address this objective.

### Summary of the invention

In accordance with the present invention in a first aspect there is provided a Field Programmable Gate Array capable of implementing a logic function. The Field Programmable Gate Array comprises a plurality of programmable elements, and is characterized by further comprising a plurality of program storage elements, each programmable element having at least one programming input coupled to an output of a respective said program storage element via a respective coupling device wherein each said coupling device comprises an activation input, and wherein the activation inputs of each said coupling device are ganged together. A value stored in each program storage element determines the operation of the respective programmable element, such that on activation of the activation input the values of the program storage elements are transferred via a respective coupling device to determine the operation of the respective programmable element to which they are coupled.

This approach allows switching from one bitstream (corresponding to an application), previously sent to a new one, that was sent in background, in very fast time (only one clock cycle).

While first application runs, a second bitstream is sent in "background" at the same time, without "alter" the first application behavior. In a clock cycle, FPGA can shift from first bitstream to second one.

Switching from first application to second one in one clock cycle allow more applications and possibilities for the user, as well as speeding up processing and allow to use smallest FPGA for 2 different computations if not needed at the same time.

The same programming bitstream can be re-loaded regularly to prevent Single Event Upsets (SEU) on the programming shift registers.

In accordance with a development of the first aspect the plurality of program storage elements are flip flops arranged in a shift register.

In accordance with a development of the first aspect the Field Programmable Gate Array is adapted to initiate the activation input at one or more predetermined instants.

In accordance with a development of the first aspect the Field Programmable Gate Array is adapted to initiate said activation input at a plurality of predetermined instants so as to periodically refresh the values of each programmable element.

In accordance with a development of the first aspect the Field Programmable Gate Array is adapted to terminate said activation input a predetermined period after each initiation of the activation input.

In accordance with a development of the first aspect the Field Programmable Gate Array is adapted to operate in a first mode wherein the program storage elements are loaded with predefined test values, and a second mode in which the program storage elements are loaded with values implementing the logic function.

In accordance with a development of the first aspect the one or more coupling devices are flip-flops.

In accordance with a development of the first aspect the one or more coupling devices are latches.

In accordance with a development of the first aspect the program storage elements are flip-flops, configured as a shift register, and the shift register is one of a plurality of such shift registers configured to supply different parts of the Field Programmable Gate Array.

In accordance with a development of the first aspect the Field Programmable Gate Array further comprises an addressing system whereby any of the plurality of shift registers may be individually or by group addressed in order to be loaded with the predefined test values in the first mode or the values implementing the logic function in the second mode.

In accordance with a development of the first aspect the program storage elements are flip-flops, configured as a shift register and each flip-flop is coupled to the next flip-flop in the shift register via a respective read-out multiplexer, each read-out multiplexer receiving a further input from the output of the respective coupling device via which a respective programmable element is coupled to that flip-flop, the selection inputs of each read-out multiplexer being ganged together such that a first read-out signal value causes the value of each coupling device to be read back into respective flip-flops of the shift register, and a second read-out signal value causes the value of each flip-flop to pass to the next respective flip-flop of the shift register.

In accordance with a development of the first aspect the output of each program storage element is connected to a respective said programmable element via a data input of a respective programme selection multiplexer, each programme selection multiplexer receiving a further data input from the output of the respective coupling device via which a respective programmable element is coupled to that program storage element, the selection inputs of each said programme selection multiplexer being ganged together such that a first programme selection signal value causes the values of each coupling device to be transferred to a respective programmable element, and a second programme selection signal value causes the values of each program storage element to be transferred to a respective programmable element.

In accordance with a development of the first aspect each said programmable element has at least one programming input coupled to an output of a respective program storage element via a respective first said coupling device and a respective second said coupling device, and wherein the programme selection multiplexer receives a data input from the output of each of the respective said coupling devices via which a respective said programmable element is coupled to that said program storage elements , the selection inputs of each said programme selection multiplexer being ganged together such that a first programme selection signal value causes the respective values of a first coupling device coupled to each programmable element to be transferred to that respective programmable element, and a second programme selection signal value causes the respective values of the second said coupling device coupled to each programmable element to be transferred to that respective programmable element.

In accordance with a development of the first aspect the Field programmable gate array is further adapted to toggle between the first program selection signal and the second program selection signal at predetermined intervals.

In accordance with the invention in a second aspect there is provided a method of programming a Field Programmable Gate Array comprising a plurality of programmable elements, the method comprising the steps of:
loading a plurality of program storage elements with values determining a desired configuration of said FPGA, each programmable element having at least one programming input coupled to an output of a respective program storage element via a respective coupling device, and
simultaneously activating each coupling device to transfer the values determining a desired configuration to the respective programmable element to which they are coupled.

In accordance with the invention in a second aspect there is provided a computer program adapted to implement the steps of claim 15.

### Brief Description of the Drawings

The above and other advantages of the present invention will now be described with reference to the accompanying drawings, in which:
Figure 1 shows schematically an example of an FPGA system as known in the state of the art;
Figure 2 shows further detail of elements of an FPGA system as known in the state of the art;
Figure 3 shows elements of an FPGA system in accordance with an embodiment of the present invention;
Figure 4 shows elements of an FPGA system in accordance with a development of the embodiment of figure 3;
Figure 5 shows elements of an FPGA system in accordance with a further embodiment of the present invention;
Figure 6 shows elements of an FPGA system in accordance with a further embodiment of the present invention;
Figure 7 shows elements of an FPGA system in accordance with a further embodiment of the present invention;
Figure 8 shows elements of an FPGA system in accordance with a further embodiment of the present invention;
Figure 9 shows a first configuration for the configuration of FPGA circuitry;
Figure 10 shows a second configuration for the configuration of FPGA circuitry;
Figure 11 shows a second configuration for the configuration of FPGA circuitry;
Figure 12 shows a modification of the structure of figure 9 adapted for configuration readout;
Figure 13 shows a modification of the structure of figure 11 adapted for configuration readout;
Figure 14 shows further detail of an operational unit in accordance with a further embodiment;
Figure 15 shows a method of programming a Field Programmable Gate Array comprising a plurality of programmable elements in accordance with an embodiment; and
Figure 16 shows a generic computing system suitable for implementation of embodiments of the invention.

### Detailed description

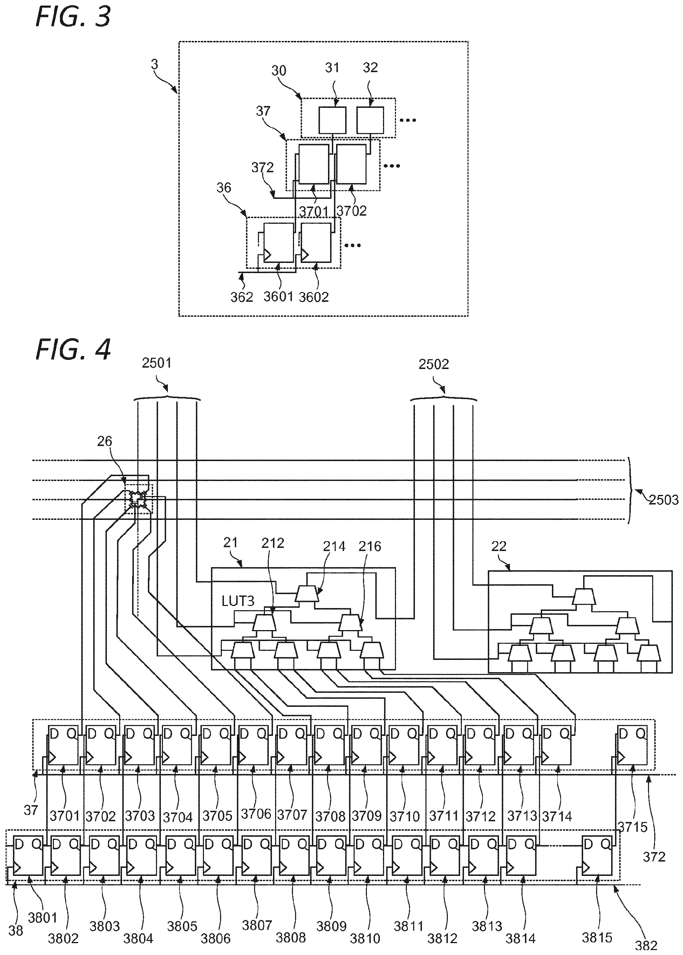

Figure 3 shows elements of an FPGA system in accordance with an embodiment of the present invention.

The elements shown in figure 3 constitute a representative example of a partial implementation of parts of the functionality described above with respect to figure 1 in accordance with an embodiment of the present invention.

As shown, there is provided a Field Programmable Gate Array 3 capable of implementing a logic function. The Field Programmable Gate Array comprises a plurality of programmable elements 31, 32, and a plurality of program storage elements 3601, 3602, where each programmable element 31,32 has at least one programming input coupled to an output of a respective program storage element 3601, 3602 via a respective coupling device 3701, 3702 wherein each said coupling device 3701, 3702 comprises an activation input 372, and wherein the activation inputs of each coupling device are ganged together, such that in operation the set of coupling devices 37 are loaded with values determining a desired operation on activation of the activation input 372 from the program storage elements 36, such that a value stored in program storage elements 36 are transferred via respective set of coupling devices 37 to determine the operation of the respective programmable element 31, 32 to which they are coupled. The data inputs of the programmable storage elements 3601, 3602 are not shown- in some embodiments the may be individually addressed for example as described with respect to figure 2. The programmable storage elements 3601, 3602 may be latches, flip-flops, memory cells or any other type of data storage element, and coupling devices 3701, 3702 may be latches, flip-flops, memory cells or any other type of data storage element with a proper system in order to have an activation input.

By way of example, a number of variants of this structure will now be described.

Figure 4 shows elements of an FPGA system in accordance with a development of the embodiment of figure 3.

As shown in figure 4, there is provided a first Look Up Table (LUT) 21, and a second Look Up Table (LUT) 22, and a number of further LUTs (not shown). The first LUT 21 comprises seven two-input multiplexers 211, 212, 213, 214, 215, 216, 217 as described with reference to figure 2 (reference signs omitted from figure 3) respectively. The second LUT and further LUTs are configured similarly. These multiplexers are arranged in a cascading manner with three rows so as to constitute an 8 input multiplexer, the output of which constitutes the output of the LUT. The first row of multiplexers (211, 213, 215 and 217) in each cascade arrangement both have a total of eight inputs. These eight inputs constitute the programming inputs of the first LUT 21. The selection inputs of each row are ganged together, to constitute the three data inputs of the LUT. The data inputs and data output of the first LUT are connected to a set of tracks 2501, 2502. The inputs and outputs of the second and further LUTs are connected correspondingly to a network of further tracks (not shown). Conventionally a LUT with 3 data inputs in this manner is referred to as a "LUT3".

The LUTs 21 and 22, and the programmable switch 26 are examples of programmable elements as described with reference to figure 3. Other programmable elements may include input/output terminals, application specific logic blocks, and any other part of the FPGA device whose operational behaviour may be configured by setting a stored value.

The system of figure 4 furthermore implements an interconnection mechanism similar to that described with respect to figure 2 above. In accordance with this embodiment however, each transistor switch of the programmable switch unit 26 is set to be open or closed by a value received from a respective coupling device 3701, 3702, 3703, 3704, 3705, 3706. Further such programmable switching units, with corresponding coupling devices are provided at many or all intersection of tracks (not shown). These coupling devices each have a data input (receiving a value from a flip-flop), a data output (coupled to a programmable element), and an activation input whereby the data value is made available on the data output in response to a predetermined value at said activation input. As shown, the activation inputs of each coupling device are ganged together on activation line 372.

Furthermore In accordance with this embodiment, each of the eight programming inputs of the first LUT 21 is connected to a respective coupling device 3707, 3708, 3709, 3710, 3711, 3712, 3713, 3714. As shown, the coupling devices are D flip flops, however the coupling devices may be latches, other types of flip flop or any other memory device as appropriate.

Similarly, the configuration inputs of the second LUT 22 and other LUTs provided in the system (not shown) are provided by further coupling device (not shown).

Furthermore, in the embodiment of figure 4, the programmable storage elements 3801, 3802, 3803, 3804, 3805, 3806, 3807, 3808, 3809, 3810, 3811, 3812, 3813, 3814, 3815 are arranged in a shift register configuration in accordance with this embodiment.

In operation, these coupling devices provide a constant predetermined logical value to each of the eight programming inputs of each LUT, in the same way as the SRAM devices described with reference to figure 2.

Thus while the present embodiment is described in the context of the configuration of LUTs 21 and 22, and the programmable switch 26, the same approach may be applied to any programmable element as discussed above.

In accordance with this embodiment, each of the coupling device 3701, 3702, 3703, 3704, 3705, 3706, 3707, 3708, 3709, 3710, 3711, 3712, 3713, 3714 receives a data input from a respective flip-flop 3801, 3802, 3803, 3804, 3805, 3806, 3807, 3808, 3809, 3810, 3811, 3812, 3813, 3814. These flip-flops 3801, 3802, 3803, 3804, 3805, 3806, 3807, 3808, 3809, 3810, 3811, 3812, 3813, 3814 are connected each to the next so as to constitute a shift register. As shown, these flip-flops are D flip-flops, where the Q terminal of each is connected to the D terminal of the next, as well as to the data input of the respective coupling device 3701, 3702, 3703, 3704, 3705, 3706, 3707, 3708, 3709, 3710, 3711, 3712, 3713, 3714, and the activation clock inputs of each flip flop are ganged together in a single clock line 372.

Accordingly, during an initiation phase for the circuit a bitstream corresponding to the desired final value of each coupling device to implement whatever logic function is required of the FPGA is input to the first flip-flop 3801 in the programming shift register formed in the present embodiment by the set of program storage elements 38 bit by bit, and clocked along the programming shift register formed in the present embodiment by the set of program storage elements one bit at a time until the first bit reaches the last flip flop, and the first flip flop receives its final value. In the present embodiment, this bit-by-bit transfer my means of the shift register is performed by activating line 382 for each bit, for example, with each successive clock edge.

At the same time, or some later time as required, the coupling activation line 372 may also be activated, such that each coupling device transfers the value on the output of the respective flip flop to the corresponding terminal of the respective programmable element, thus for example defining the values of the routing switches and the LUT configuration inputs as described above. In the present embodiment, the transfer between the coupling device is performed by activating line 372 once, for example on one single clock edge, as discussed further hereafter.

Replacing convention SRAM memory cells with flip flops as described here generally implies an increase in transistor count, and accordingly goes against standard IC design imperatives.

By adopting flip flops to control the routing switches and LUT configuration inputs, it becomes possible to implement scan chain test techniques without adding extra flip flops specifically for testing purposes. This not only offsets the increase in transistor count mentioned above, but further simplifies the chip design in particular with regard to the routing and control of the test components.

Furthermore, by removing the need for addressing and data busses for a large number of SRAM cells, it is possible to economize substantially in terms of chip area usually set aside for these purposes.

By interposing a set of coupling devices between the programming shift register formed in the present embodiment by the set of program storage elements and the programmable elements, it is possible to load a second bitstream into the programming shift register formed in the present embodiment by the set of program storage elements once an initial bitstream has been loaded to the coupling devices. This second bitstream can then be loaded to the coupling devices in place of the first bitstream in a single clock cycle, i.e. by clicking the activation line 372 at the desired moment. Loading the new bitstream in this way can completely reconfigure the FPGA almost instantly, without changing the values in the operational parts of the device (i.e the current values in calculations currently underway, and the like). As such, it becomes possible to switch to an alternative, less energy intensive algorithm if power consumption exceeds a threshold, to attempt alternative processing where one approach proves too slow or otherwise ineffective, to process a particular data set in accordance with multiple algorithms in parallel, and the like.

Still further, the first bitstream may constitute test values, designed to assess proper operation of the FPGA device, whilst the second bit stream may then constitute operational values defining a desired production logic function.

The Field Programmable Gate Array may additionally be adapted to initiate the activation input 372 at one or more predetermined instants, i.e. a specified time, or in response to predetermined system conditions, e.g. crossing a power consumption, temperature, processing load, or other threshold.

The activation input 372 value may set for a predefined duration, such that the Field Programmable Gate Array is adapted to terminate the activation input a predetermined period after each initiation of said activation input.

Even if no new bitstream is loaded into the shift register formed in the present embodiment by the set of program storage elements, the described structure provides a mechanism for refreshing the programmed values of the programmable elements as stored in the coupling devices, by reactivating the activation line 372 and reloading the values from the shift register formed in the present embodiment by the set of program storage elements into the coupling devices. This step may be undertaken at regular intervals, or when an error condition is detected, or otherwise as appropriate. The shift register formed in the present embodiment by the set of program storage elements may be reloaded (with an identical bitstream) as required without affecting operation of the programmable elements. This provides a mechanism for periodically refreshing the configuration values of the programmable elements. In contexts where the configurations values may be corrupted, for example by ionising energy, such a periodic refresh may automatically correct such corrupt values.

Accordingly there is provided a Field Programmable Gate Array capable of implementing a logic function, comprising a plurality programmable elements, and characterized by further comprising a plurality of flip-flops in a shift register configuration, each programmable element having at least one programming input coupled to an output of a respective flip-flop via a respective coupling device wherein each said coupling device comprises an activation input, and wherein the activation inputs of each coupling device are ganged together. The shift register is loaded with values determining a desired configuration, such that on activation of said activation input the values of said flip-flops are transferred to the respective programmable element to which they are coupled.

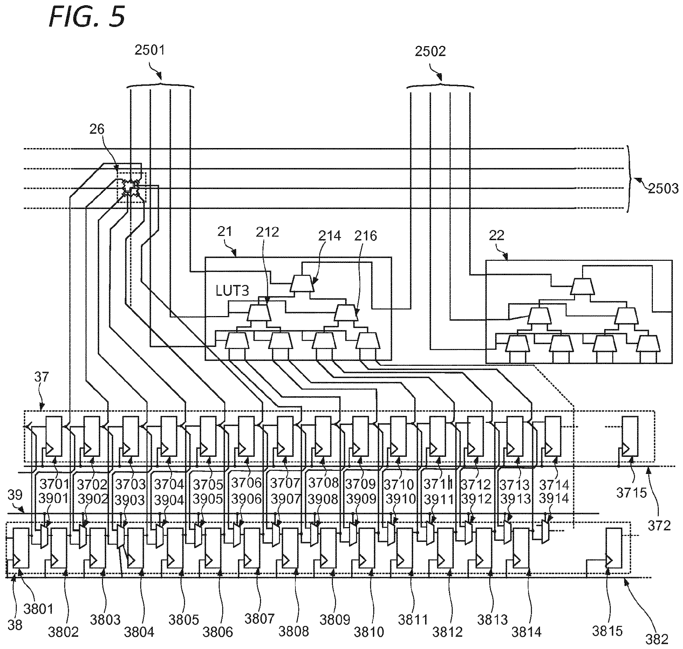

Figure 5 shows elements of an FPGA system in accordance with a further embodiment of the present invention.

The embodiment of figure 5 incorporates each of the elements described above with respect to figure 3. In figure 5 however it will be noted that the structure of the programming shift register formed in the present embodiment by the set of program storage elements 38 is amended. In particular, unlike figure 4 in which the output of each flip-flop in the programming shift register formed in the present embodiment by the set of program storage elements 38 is directly connected to the input of the next, in figure 5 a respective read-out multiplexer 3901, 3902, 3903, 3904, 3905, 3906, 3907, 3908, 3909, 3910, 3911, 3912, 3913, 3914 is interposed so as to receive an input from the output of a respective preceding flip flop 3801, 3802, 3803, 3804, 3805, 3806, 3807, 3808, 3809, 3810, 3811, 3812, 3813, 3814 of the programming shift register formed in the present embodiment by the set of program storage elements 38, and each read-out multiplexer then outputs it output value to the input of the next flip flop in the programming shift register. Thus read-out multiplexer 3901 receives an input from the output of flip flop 3801, and provides its output to flip flop 3802, which in turn provides its output to multiplexer 3902, and so on. Meanwhile, each read-out multiplexer 3901, 3902, 3903, 3904, 3905, 3906, 3907, 3908, 3909, 3910, 3911, 3912, 3913, 3914 receives a second input from a respective coupling device, in particular as shown the coupling device receiving its input from the programming flip flop corresponding to the one providing its output to the respective read-out multiplexer, so that read-out multiplexer 3902 receives its second input from coupling device 3702, which receives its programming input from program storage element 3802, and so on.

The select input of all the read-out multiplexers are ganged together so that depending on the value on this common read-out select line 39 the flip-flops in the programming shift register formed in the present embodiment by the set of program storage elements 38 either receive their input values from the preceding flip flop in the shift register in a first configuration, or from a corresponding coupling device in a second configuration.

In operation, it thus becomes possible to read the current values of the coupling devices back into the shift register formed in the present embodiment by the set of program storage elements, which can then be clocked to recover the values. This makes it possible to assess the values to determine whether any corruption has occurred. This operation may be performed for example at the end of a processing sequence, to confirm that the results are the product of the correct programming values, thereby validating the results, or otherwise invalidating the results, in which case the programming values may be reloaded and the processing sequence repeated.

Accordingly, each program storage element in the shift register formed in the present embodiment by the set of program storage elements may be coupled to the next program storage element in the shift register via a respective read-out multiplexer, each read-out multiplexer receiving a further input from the output of the respective coupling device via which a respective programmable element is coupled to that said flip-flop, the selection inputs of each read-out multiplexer being ganged together such that a first read-out signal value causes the values of each coupling device to be read back into respective flip-flops of the shift register, and a second read-out signal value causes the values of each flip-flop to pass to the next respective flip-flop of the shift register.

In operation, the arrangement of figure 5 further supports a method of verifying an FPGA. This method may comprise the steps of setting each read out multiplexer to couple the output of each coupling device to the input of a respective flip flop of the shift register, and then clocking the programming shift register to read out a first set of elements thereof with said LUT Configuration values implementing a logic function. The values read out may then be compared to the initial programming values.

In accordance with a development of this embodiment, the method may comprise the additional steps of enabling the output of a first set of program storage elements from a plurality of programming shift registers, implementing the operation describe above with respect to the first programming shift register, and then repeating these steps for each of said plurality of shift registers.

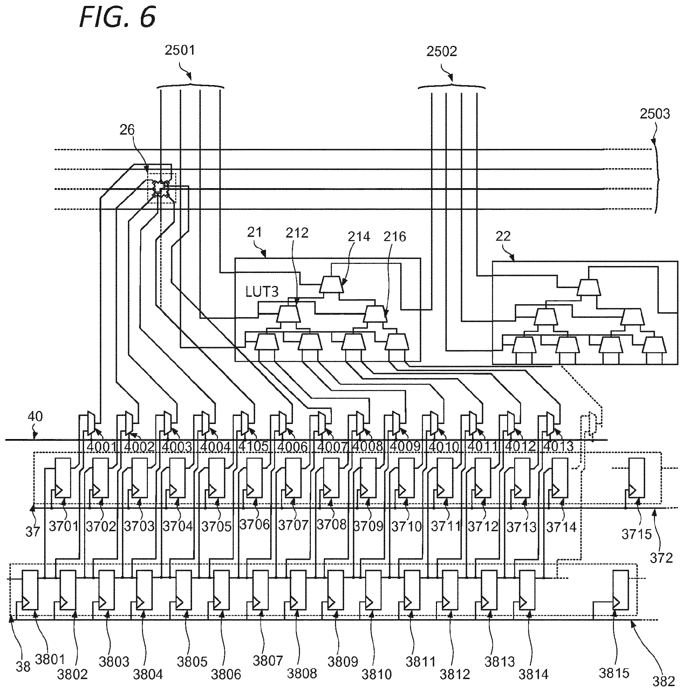

Figure 6 shows elements of an FPGA system in accordance with a further embodiment of the present invention.

The embodiment of figure 6 incorporates each of the elements described above with respect to figure 3. In figure 5 however it will be noted that the structure of the set of coupling devices 37 is amended. In particular, unlike figure 4 in which the output of each coupling device is directly connected to the respective programmable element, in figure 6 a respective programme selection multiplexer 4001, 4002, 4003, 4004, 4005, 4006, 4007, 4008, 4009, 4010, 4011, 4012, 4013 is interposed so as to receive an input from the output of a respective preceding coupling device 3701, 3702, 3703, 3704, 3705, 3706, 3707, 3708, 3709, 3710, 3711, 3712, 3713. Meanwhile each programme selection multiplexer receives a second respective input from a respective output of a storage element in the set of program storage elements 38 constituting in the embodiment of figure 6 a programming shift register. Thus as shown for example programme selection multiplexer 4001 receives inputs from coupling device 3701 and programming shift register flip-flop 3801. The select inputs of each of the programme selection multiplexers 4001, 4002, 4003, 4004, 4005, 4006, 4007, 4008, 4009, 4010, 4011, 4012, 4013 are ganged together such that a first programme selection signal value on the resulting programme selection line 40 causes each programmable element to receive its programming value from a respective coupling device for example as described with reference to figure 4, and a second programme selection signal value causes each programmable element to receive its programming value from a respective flip-flop of the programming shift register.

By this means, it is possible to load a first set of values into the coupling devices, and then a second set into the shift register without clocking the coupling devices to load them with the new values. It is then possible at any time to switch between the programming values in the coupling devices and the programming values in the shift register simply by setting the programme selection value on line 40 to either the first or second value. Accordingly, an instantaneous switching between two programmes in the same FPGA becomes possible. This switching or toggling may occur as required, or at predetermined intervals or otherwise.

Accordingly, there may be provided a Field Programmable Gate Array wherein the output of each program storage element is connected to a respective programmable element via a data input of a respective programme selection multiplexer, each said programme selection multiplexer receiving a further data input from the output of the respective coupling device via which a respective programmable element is coupled to that program storage element, the selection inputs of each programme selection multiplexer being ganged together such that a first programme selection signal value causes the values of each coupling device to be transferred to a respective programmable element, and a second programme selection signal value causes the values of each program storage element to be transferred to a respective programmable element.

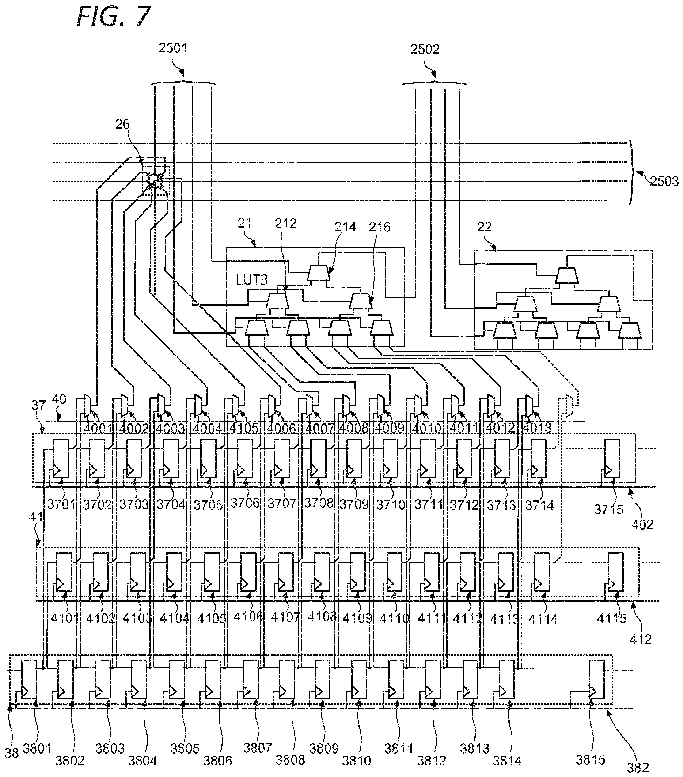

Figure 7 shows elements of an FPGA system in accordance with a further embodiment of the present invention.

The embodiment of figure 7 incorporates each of the elements described above with respect to figure 4. In figure 7 however it will be noted that the structure of the set of coupling devices 37 is amended. In particular, there is provided a second set of coupling devices 41, with each coupling device 4101, 4102, 4103, 4104, 4105, 4106, 4107, 4108, 4109, 4110, 4111, 4112, 4113 4114 in this second set receiving an input value from a respective program storage element in the programming shift register 38 in the same way as the coupling devices in the first set of coupling devices 37 as described above. The clock inputs of the coupling devices in the second set 41 are ganged together on a single clock line 412.

By this means, a first set of programme values may be loaded into the set of program storage elements 38 forming the programming shift register and then clocked to one of the two sets of coupling devices, and then a second set of programme values may be loaded in to the programming shift register and then clocked to the other of the two sets of coupling devices.

Furthermore, unlike figure 4 in which the output of each coupling device is directly connected to the respective programmable element, in figure 7 a respective programme selection multiplexer 4001, 4002, 4003, 4004, 4005, 4006, 4007, 4008, 4009, 4010, 4011, 4012, 4013 is interposed so as to receive an input from the output of a respective preceding coupling device in the first set of coupling devices 3701, 3702, 3703, 3704, 3705, 3706, 3707, 3708, 3709, 3710, 3711, 3712, 3713. Meanwhile each programme selection multiplexer receives a second respective input from the output of a respective preceding coupling device in the second set of coupling 4101, 4102, 4103, 4104, 4105, 4106, 4107, 4108, 4109, 4110, 4111, 4112, 4113 4114. Thus as shown for example programme selection multiplexer 4001 receives inputs from coupling device 3701 in the first set of coupling devices 37 and from coupling device 4101 in the second set of coupling devices 41. The select inputs of each of the programme selection multiplexers 4001, 4002, 4003, 4004, 4005, 4006, 4007, 4008, 4009, 4010, 4011, 4012, 4013 are ganged together such that a first programme selection signal value on the resulting programme selection line 40 causes each programmable element to receive its programming value from a respective coupling device in the first set for example as described with reference to figure 4, and a second programme selection signal value causes each programmable element to receive its programming value from value from a respective coupling device in the second set.

By this means, it is possible to load a first set of values into the first set coupling devices, and then a second set into the second set of coupling devices. It is then possible at any time to switch between the programming values in the first set of coupling devices and the programming values in the second set of coupling devices simply by setting the programme selection value on line 40 to either the first or second value. Accordingly, an instantaneous switching between two programmes in the same FPGA becomes possible. This switching or toggling may occur as required, or at predetermined intervals or otherwise.

It will be appreciated that while the embodiment of figure 7 shows two coupling devices being provided for each programmable element, any number of coupling devices may be provided for each programmable element with a correspondingly larger multiplexer, so that the FPGA may instantaneously switch between any number of programmes as required.

It will also be appreciated that the embodiments of figures 6 and figure 7 may be combined, so that each programmable element may receive its input from any one of a plurality of coupling devices as described with respect to figure 7, and also directly from the set of program storage elements 38 as described with reference to figure 6, with the size of the programme select multiplexer of each programmable element being fixed accordingly.

Accordingly, there may be provided a Field Programmable Gate Array wherein each programmable element has at least one programming input coupled to an output of a respective said program storage element via a respective first coupling device and a respective second coupling device, and wherein the programme selection multiplexer receives a data input from the output of each of the respective coupling devices via which a respective programmable element is coupled to that program storage element, the selection inputs of each programme selection multiplexer being ganged together such that a first programme selection signal value causes the respective values of a first coupling device coupled to each programmable element to be transferred to that respective programmable element, and a second programme selection signal value causes the respective values of second coupling device coupled to each programmable element to be transferred to that respective programmable element.

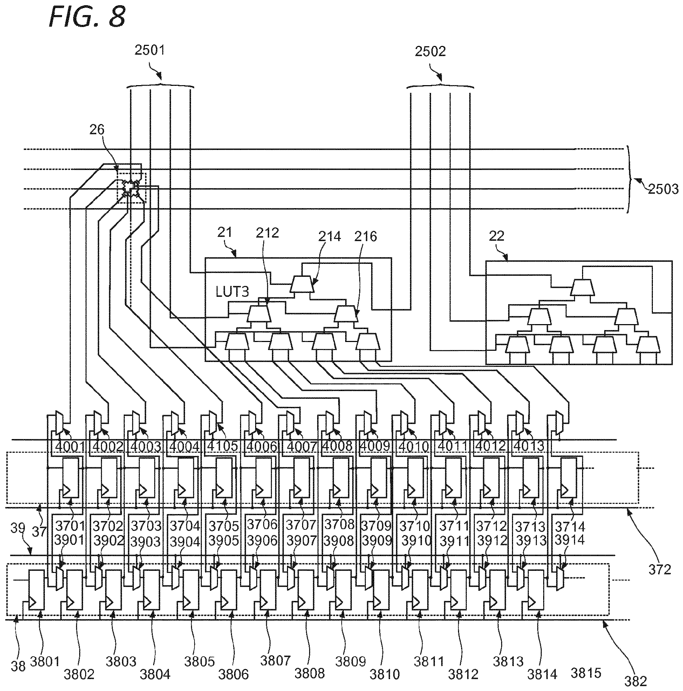

Figure 8 shows elements of an FPGA system in accordance with a further embodiment of the present invention.

The embodiment of figure 8 incorporates each of the elements described above with respect to figures 5 and 6 in combination. Specifically, on one hand a respective read-out multiplexer 3901, 3902, 3903, 3904, 3905, 3906, 3907, 3908, 3909, 3910, 3911, 3912, 3913, 3914 is interposed so as to receive an input from the output of a respective preceding program storage element 3801, 3802, 3803, 3804, 3805, 3806, 3807, 3808, 3809, 3810, 3811, 3812, 3813, 3814, which as shown in figure 8 constitute a programming shift register, and each read-out multiplexer then outputs it output value to the input of the next program storage element in the programming shift register. Thus read-out multiplexer 3901 receives an input from the output of program storage element 3801, and provides its output to program storage element 3802, which in turn provides its output to multiplexer 3902, and so on. Meanwhile, each read-out multiplexer 3901, 3902, 3903, 3904, 3905, 3906, 3907, 3908, 3909, 3910, 3911, 3912, 3913, 3914 receives a second input from a respective coupling device, in particular as shown the coupling device receiving its input from the program storage element preceding the one providing its output to the respective read-out multiplexer, so that read-out multiplexer 3901 receives its second input from coupling device 3701, which receives its programming input from the set of program storage elements 3801, and so on. The select input of all the read-out multiplexers are ganged together so that depending on the value on this common read-out select line 39 the program storage elements in the programming shift register either receive their input values from the preceding program storage element in the shift register in a first configuration, or from a corresponding coupling device in a second configuration.

Meanwhile, on the other hand a respective programme selection multiplexer 4001, 4002, 4003, 4004, 4005, 4006, 4007, 4008, 4009, 4010, 4011, 4012, 4013 is interposed so as to receive an input from the output of a respective preceding coupling device 3701, 3702, 3703, 3704, 3705, 3706, 3707, 3708, 3709, 3710, 3711, 3712, 3713. Meanwhile each programme selection multiplexer receives a second respective input from a respective output of a program storage element in the programming shift register 38. Thus as shown for example programme selection multiplexer 4001 receives inputs from coupling device 3701 and program storage element 3801. The select inputs of each of the programme selection multiplexers 4001, 4002, 4003, 4004, 4005, 4006, 4007, 4008, 4009, 4010, 4011, 4012, 4013 are ganged together such that a first programme selection signal value on the resulting programme selection line 40 causes each programmable element to receive its programming value from a respective coupling device for example as described with reference to figure 4, and a second programme selection signal value causes each programmable element to receive its programming value from a respective program storage element

By this means, it is possible to load a first set of values into the coupling devices, and then a second set into the set of program storage elements without clocking the coupling devices to load them with the new values. It is then possible at any time to switch between the programming values in the coupling devices and the programming values in the program storage element simply by setting the programme selection value on line 40 to either the first or second value. Accordingly, an instantaneous switching between two programmes in the same FPGA becomes possible.

Meanwhile, it additionally becomes possible to read the current values of the coupling devices back into the shift register formed by the program storage elements 38, which can then be clocked to recover the values. This makes it possible to assess the values to determine whether any corruption has occurred. This operation may be performed for example at the end of a processing sequence, to confirm that the results are the product of the correct programming values, thereby validating the results, or otherwise invalidating the results, in which case the programming values may be reloaded and the processing sequence repeated.

It will be appreciated that multiple coupling devices may additionally be provided for each programmable element as described for example with respect to figure 7.

It will be noted that embodiments are envisaged incorporating some of the features described with respect any of figures 3 to 8, but not necessary all features of any particular figure. For example, the shift register configuration of the set of programme storage elements 38 described with reference to figure 4 to 8 may be adopted for the structure of figure 3 without necessarily adopting any of the other features described with respect to figures 4 to 8.

While figures 3 to 8 show a single set of programme storage elements 38, it will be appreciated that as the proposed mechanism is scaled to incorporate more LUTs and programmable switching units, it may become desirable to implement multiple or multidimensional programming shift registers.

Accordingly, the programming shift register formed in certain embodiments by the set of program storage elements for example as described with reference to figures 4 to 8 may be one of a plurality of such programming shift registers configured to supply different parts of said Field Programmable Gate Array.

Such a plurality of programming shift registers may be configured to be loaded with the predefined test values in the first mode or said values implementing the logic function in the second mode in parallel or in series.

The skilled person will appreciate that while the system of figures 3 to 8 has been highly simplified, real systems will be considerably more complex without departing from the principles described herein. In particular, each logic block may comprise more than one LUT, and may further comprise additional logic for example to support extended functionality, or to introduce sequential control. A number of such logic blocks may be arranged together in groups.

Referring back to fig. 1, it is apparent that while the tracks 14 that provide connectivity between tiles in an operational mode are shown schematically, the address and data busses 23 and 24 are not shown, and in a real device will contribute very substantially to the surface area of the device. The programming shift register arrangement of figures 3 to 8 addresses this issue, since it becomes possible to load the bitstream for a large number of memory devices into the programming shift register, without needing to individually address each memory cell. This is both simpler in operation, and less demanding in terms of surface area as concerns addressing and bus tracks. It will be appreciated that it may nevertheless not be desirable to provide a single programming shift register incorporating every configuration cell for an entire FPGA device, since such a programming shift register will become unmanageably long, with implications for clock management, power consumption and the like. It is meanwhile possible to adopt an approach based on multiple programming shift registers, which each programming shift register managing the configuration settings for a particular part of the chip. The first flip flop in each such programming shift register, or group of programming shift registers, can be addressed in a similar manner to the individual memory cells of figure 2, or otherwise. The choice of the length of each programming shift register then becomes a compromise between longer programming shift registers with simpler configuration bit stream distribution on one hand, and shorter programming shift registers with more complex configuration bitstream distribution on the other, which may imply wider busses and or more complex addressing. The optimal compromise in any given case will depend on the semiconductor technology in use, and various characteristics of the FPGA circuit itself.

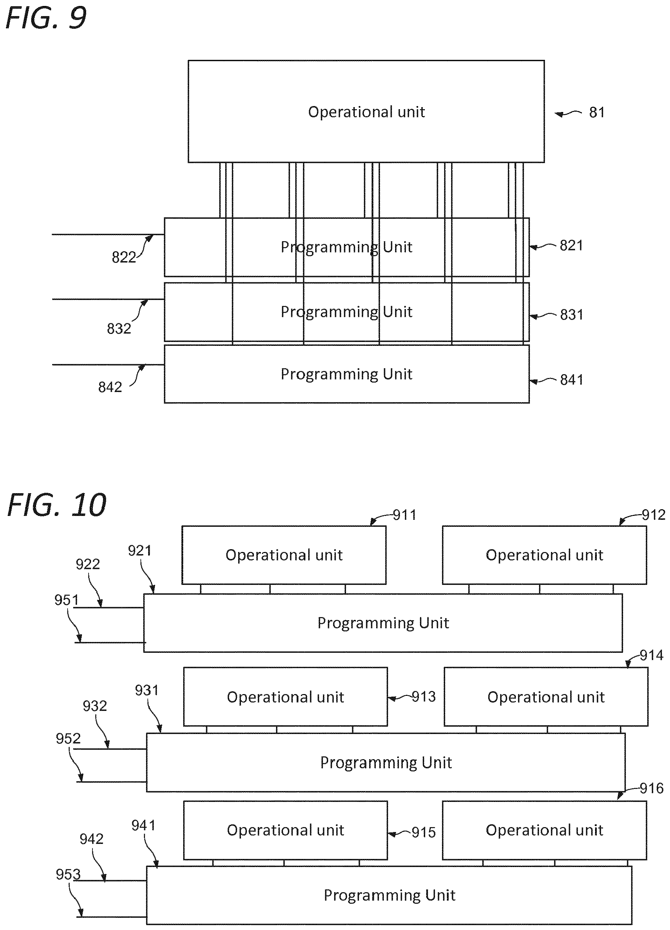

Figure 9 shows a first configuration for the configuration of FPGA circuitry. As shown, there is provided an operational unit 81 comprising one or more LUTs, possibly with ancillary circuitry and corresponding programmable routing switches, etc. As shown, this operational unit 81 is provided with configuration values by three programming units 821, 831 and 841, each comprising a programming shift register and at least one set of coupling devices as described above, each programming unit receiving input values from three input connections 822, 832, 842, and each having a respective clock 851, 852, 853. Other clock and program select lines may be provided for each programming unit for example as provided in any of the preceeding embodiments (not shown).

As shown, the three programming shift registers each have only five outputs to the operational unit 81, however it will be appreciated that in working implementations the programming shift registers will generally be significantly longer. Working implementations will also generally comprise more than three programming shift registers. The programming shift registers are shown as all comprising the same number of outputs, and correspondingly flip flops, however in some cases certain programming shift register may comprise any number of flip flops.

Consideration must be given to the clocking of the different programming shift registers to ensure that the proper value reaches each flip flop. This implies that each programming shift register should receive a number of clock pulses equal to its length and no more, since further pulses would lead to values being clocked onward beyond their proper destination. One approach to this problem is to define all programming shift registers as having the same length as shown in figure 9. Alternatively, where shift registers of different lengths are defined, they may be associated with clock management circuitry adapted to ensure that each shift register receives a number of clock signals equal to its length during a the initialization phase. According to a still further approach, each programming shift register may be provided with clock management circuit adapted to recognize a particular bit sequence indicating a particular position in the bitstream intended for that shift register, such as the beginning or end of the bitstream. When the clock manager detects this sequence, it disables the clock entry. This approach has the advantage of making each shift register independent, and leaving the designer the freedom to define programming shift registers of arbitrary size. Alternatively, switching between signals and clocking of programming shift registers may be driven by software.

Figure 10 shows a second configuration for the configuration of FPGA circuitry. As shown in figure 10, the FPGA is structured around a matrix of logic blocks 911, 912, 913, 914, 915, 916, in a similar way to the FPGA of figure 1. Each row of logic blocks is provided with a respective programming unit each comprising a programming shift register and at least one set of coupling devices as described above, so that logic blocks 911 and 912 receive configuration values from programming shift register 921, that logic blocks 913 and 914 receive configuration values from programming shift register 931, and logic blocks 915 and 916 receive configuration values from programming shift register 941. As shown, the three programming units each comprise six outputs, and hence 6 program storage elements, which in the present embodiment are shown as flip flops and 6 coupling devices in each set of which three are coupled to each logic block. All of the flip flops in a respective programming shift register have their clock inputs in common, while each programming shift register has its own respective clock 951, 952, 953.

As shown, the three programming shift registers have only six program storage elements, however it will be appreciated that in working implementations the programming shift registers will generally be significantly longer. Working implementations will also generally comprise more than three programming shift registers. The programming shift registers are shown as all comprising the same number of flip flops, however in some cases this may be an unacceptable design constraint, in which each programming shift register may comprise any number program storage element s.

Consideration may be given to the clocking of the different programming shift registers to ensure that the proper value reaches each flip flop, in which regard similar measures as discussed above with respect to figure 9 are applicable.

The multiplexing between an operational bitstream and test pattern may be implemented for example as described with regard to the foregoing embodiments. The distribution of the operational bitstream or test pattern, and respectively clock signals, may be distributed among programming shift registers for example as described with regard to the foregoing embodiments.

By implementing a direct structural correspondence between the programming shift register architecture and the layout of the logic blocks, a structured approach to the generation of the configuration bitstream is imposed, which is likely to facilitate programming of the FPGA.

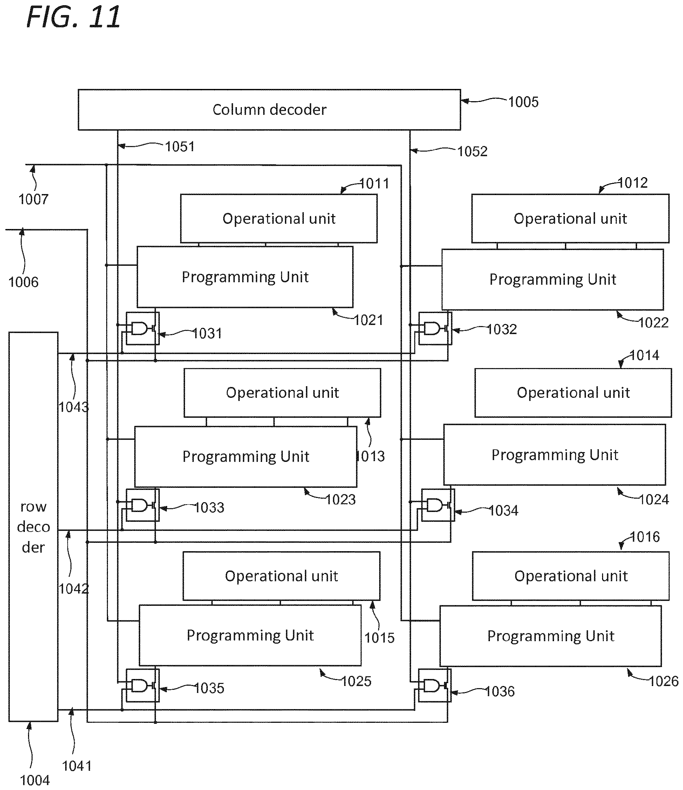

Figure 11 shows a second configuration for the configuration of FPGA circuitry. As shown in figure 11, the FPGA is structured around a matrix of logic blocks 1011, 1012, 1013, 1014, 1015, 1016, in a similar way to the FPGA of figure 10. Each logic block is provided with a respective programming shift register 1021, 1022, 1023, 1024, 1025, 1026 comprising program storage elements as described above. As shown, the six programming shift units 1021, 1022, 1023, 1024, 1025, 1026 each comprise a programming shift register, and at least one set of coupling devices. As shown each programming unit provides three outputs, and thus has three program storage element flip flops in its respective programming shift register, providing configuration values for their associated logic block.

The first flip flop of each programming shift register receives its input on an input line 1007, which is coupled in common to the D input of the first flip-flop of each programming shift register.

All of the flip flops in each programming shift register have their clock inputs in common.

A single clock distribution network 1006 is coupled to the clock line of each programming shift register by a respective clock gate 1031, 1032, 1033, 1034, 1035, 1036. These clock gates as shown each have a row select and a column select input, whereby concurrent logical highs on both inputs close a switch connecting the clock line of the respective programming shift register to the clock distribution network 1006 to receive clock pulses.

As shown there are 2 column select lines 1051 and 1052, and 3 row lines 1041, 1042, 1043. The select inputs of each clock gate is connected to a respectively different combination of column select line and row select line, so that by setting a particular column select line and row select line to a logical high, the single clock gate having its row select input and a column select input connected to those two select lines will be activated.

Since data values from the input line will only be propagated through a programming shift register when that receives clock inputs, by directing the clock signal to one selected programming shift register it is possible to selectively program any programming shift register with a single input line 1007.

The column select lines 1051, 1052 are controlled by a column decoder 1005, and the row select lines 1041, 1042, 1043 are controlled by a row decoder 1004. These decoders receive instructions coordinated with the values on the input line 1007 to address the value on the input line 1007 to whichever programming shift register it is intended for. As such, during an initialization phase the circuit of figure 11 will receive not only the configuration bitstream on line 1007 and the clock on line 1006, but also an addressing bitstream at the decoders 1004 and 1005.

The fact that only the subset of flip flops, i.e. those belonging to the logic blocks being programmed at a given time are clocked, results in significant reduction in power consumption.

It will be appreciated that in real systems implemented in an FPGA, many logic blocks will be configured identically to implement common functions. It is an advantage of the present invention that it may be possible to enable the clock gate of more than one programming shift register so that the same configuration values can be clocked into several programming shift registers in parallel. This reduces the initialization time of the FPGA, and reduces power consumption.

As shown, the three programming units have only three program storage elements in their respective programming shift registers, however it will be appreciated that in working implementations the programming shift registers will generally be significantly longer. Working implementations will also generally comprise more than six logic blocks and correspondingly more than six programming shift registers. The programming shift registers are shown as all comprising the same number of program storage elements, however since each programming shift register is clocked independently the approach of figure 11 is equally well suited to arrangements in which each programming shift register may comprise any number of flip flops.

This addressing functionality may also be implemented by means of standard integrated clock gating cells, or otherwise. Certain embodiments may provide for common enablement of a group of or all sets of program storage elements together with individual addressing.

By implementing a direct structural correspondence between the programming shift register architecture and the layout of the logic blocks, a structured approach to the generation of the configuration bitstream is imposed, which is likely to facilitate programming of the FPGA.

It will be appreciated that a given FPGA may be subdivided into sections which are programmed independently, and that combinations of various programming shift register architectures for example as described with regard to figures 9, 10 and 11 are possible in the same FPGA with respect to different parts thereof.

In some applications it will be desirable to read back the configuration settings stored in the various configuration memory cells. Although in principle these may be expected to be identical to the configuration bitstream provided at system initialization, in practice there are certain circumstances where this may not be the case. For example exposure to ionizing radiation as may occur in outer space, high altitude flight, nuclear power and military applications, which may modify the values in configuration memory cells in a random manner, falsifying the results of subsequent processing by the FPGA. Comparing the original bitstream with the stored values read out of the configuration memory bits provides a means for determining whether this may have occurred.

As such, there is disclosed a Field Programmable Gate Array comprising an addressing system whereby any of said plurality of programming shift registers may be individually addressed in order to be loaded with said predefined test values in said first mode or said values implementing said logic function in said second mode.

Furthermore, this addressing system may comprise a respective addressable clock gate associated with each programming shift register, this clock gate being adapted to provide a clock signal to the programming shift register with which it is associated when thus addressed.

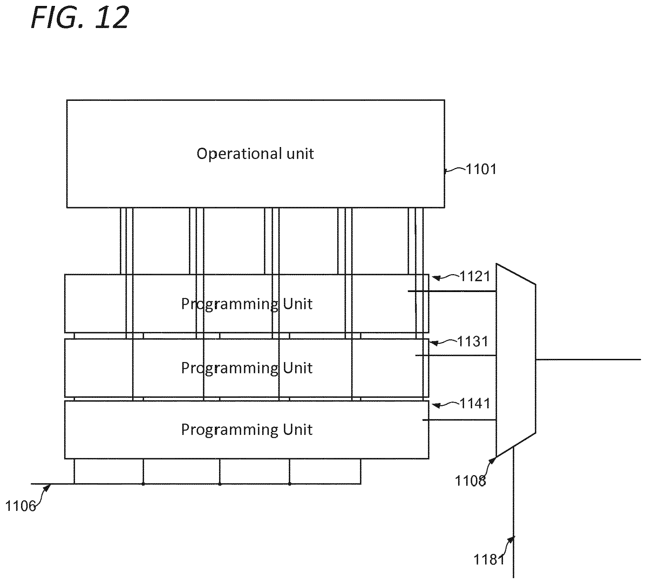

Figure 12 shows a modification of the structure of figure 9 adapted for configuration readout. As shown in figure 12, there are provided the same operation unit 81, associated with the same programming units 821, 831, 841 as described with reference to figure 9. As shown, the last program storage element (flip flop) in each of the three programming shift registers provides of the respective programming units its output not only to components of the FPGA circuitry 81, but also to a multiplexer 1108. The multiplexer 1108 thus receives inputs from the last program storage elements of each of the three programming shift registers of the respective programming units 821, 831, 841.

In operation, once the processing phase of the FPGA is complete and results have been produced, it may be desired to dump the configuration of the program storage elements as to ensure consistency with the original bitstream as discussed above. Where this is required, the programming shift registers are clocked via the clock line 1106, and the output of each programming shift register sampled by the multiplexer 1108 to produce a multiplexed bitstream which ordinarily should be identical to the original configuration bitstream. The selection signal 1181 to the multiplier may simply cause a round-robin selection of the three inputs at three times the clock frequency on clock line 1106, or may comprise a programmed sequence specific to each clock pulse, for example where the programming shift registers are of different lengths.

It will be appreciated that the approach of figure 12 is easily adaptable to structure of figure 10.

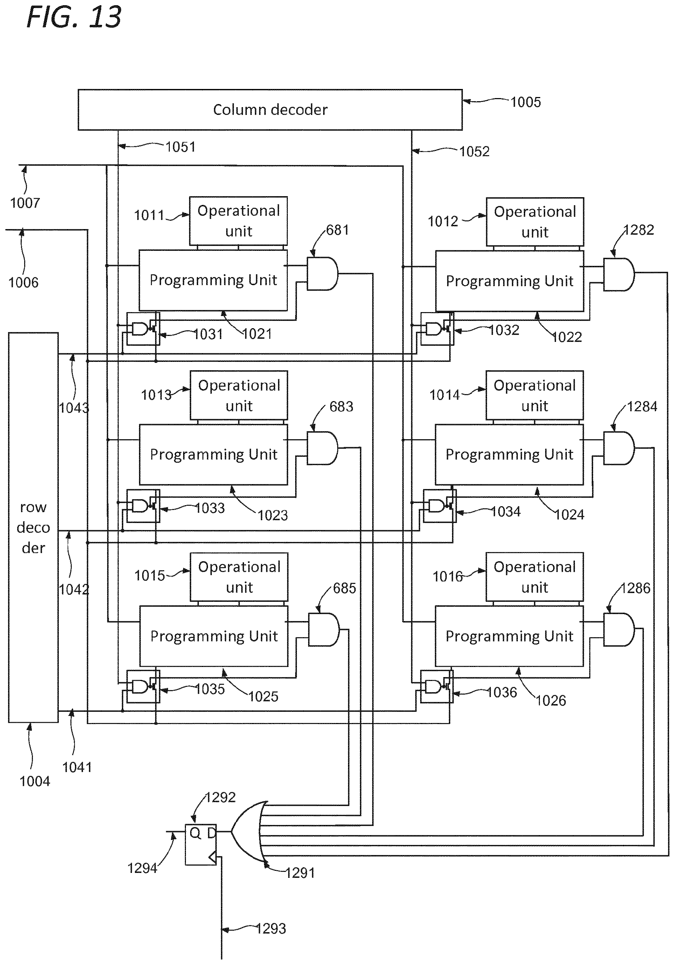

Figure 13 shows a modification of the structure of figure 11 adapted for configuration readout. As shown in figure 13, the FPGA is structured around the same matrix of logic blocks 1011, 1012, 1013, 1014, 1015, 1016, each logic block is provided with a respective programming unit 1021, 1022, 1023, 1024, 1025, 1026 and clock gates 1031, 1032, 1033, 1034, 1035, 1036 as described with regard to figure 11. As shown the structure further comprises six AND gates 1281, 1282, 1283, 1284, 1285, 1286, each having one input connected to the output of the last program storage element (flip flop) of a respective one of the six programming shift registers of the programming units 1021, 1022, 1023, 1024, 1025, 1026. The second inputs of each of the six AND gates 1281, 1282, 1283, 1284, 1285, 1286 each connected to the output of the AND gate of the respective clock gate 1031, 1032, 1033, 1034, 1035, 1036. By this means, the addressable clock enable mechanism can also be used to selectively enable an operation unit for output The outputs of the six AND gates are each connected to respective inputs of a six input OR gate 1291, the output of which feeds into the D input of an output flip flop 1292.

In operation, once the operational phase of the FPGA is complete and results have been produced, it may be desired to dump the configuration of the program storage elements to ensure consistency with the original bitstream as discussed above. Where this is required, the enable line is set to logical high, so that the selected AND gate pass the value on the output of the last flip flop of each programming shift register to the OR gate 1291. The clock gate of whichever programming shift register's values is to be output is enabled via the row decoder 1004 and column decoder 1005 in the same way as for configuration bitstream input described above, and a first clock pulse reaches the selected programming shift register. If the last flip flop in the clocked programming shift register produces a logical high, this causes the respective AND gate receiving the value to output a logical high, which is passed by the OR gate 691 to the D input of the output flip flop 1292, and stored there until the output flip flop receives a clock pulse on input 1293, whereupon the value is output on line 1294. By this means, through enabling output on via the clock gate as described above, clocking the programming shift registers and output flip flop in a coordinated manner, the stored values in each configuration programming shift register can be read out and compared to the original bitstream.

Accordingly, the Field Programmable Gate Array may further be adapted to implement a third mode of operation in which values implementing the logic function loaded into the programming shift registers in the second mode of operation are read back out of said programming shift registers.

It will be understood that certain embodiments may be described in terms of a series of method steps for programming an FPGA.

While the embodiments of figures 9 to 13 have been described generally in terms of programming shift registers comprising program storage elements as described above, in many cases the described structures may be adapted to operate with individually addressed program storage elements not in a shift register configuration, or a combination of the two approaches, even within programming units.

While the foregoing generally describes programming shift registers dedicated to either routing switches or LUT configuration, it will be appreciated that any program storage elements as in any set of program storage elements may be coupled to any FPGA element as required.

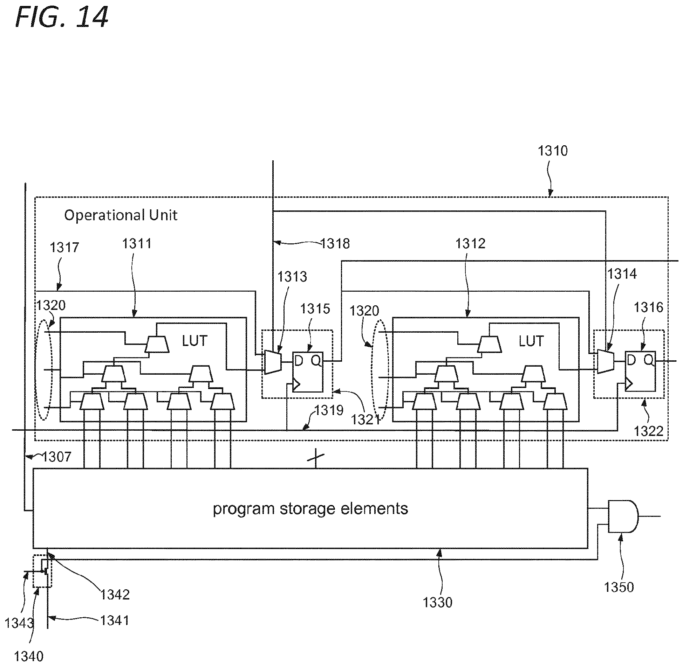

Figure 14 shows further detail of an operational unit in accordance with a further embodiment.

As shown in figure 14, there is provided an operational unit 1310 corresponding to the operational units for example as described with reference to the foregoing embodiments. This operational unit 1310 comprises two LUTs 1311 and 1312. The output of each LUT 1311, 1312 is connected to a respective multiplexer 1313, 1314. The output of these multiplexers 1313, 1314 is connected to a respective flip flop 1315, 1316. Together, a respective multiplexer 1313, 1314 and a respective flip-flop 1315, 1316, constitute a respective dual configuration LUT flip flop 1321, 1322. The second input of the multiplexer 1313 is connected to a test value input line 1317. The second input of the multiplexer 1314 is connected to the output of the LUT flip flop 1316. The selection inputs of the two multiplexers 1313, 1314 are connected in common to a test mode selection line 1318. The output of each LUT flip flop 1315, 1316 supplies an output line of the operational unit 1310. The two LUT flip flops 1315, 1316 are driven by a common clock line 1319. Each of the LUTs 1311, 1312 has three data inputs, which together constitute 6 data inputs 1320 of the operational unit. There is further provided a programming shift register 1330, corresponding to the programming shift registers for example as described with reference to the foregoing embodiments. The programming shift register provides configuration values for the LUTs 1311, 1312, and a number of programmable routing switches (not shown) substantially as described with reference to the foregoing embodiments. A clock 1341 is selectively connected to the clock line 1342 of the programming shift register 1330 by a clock gate 1340. The clock gates 1340 as shown has enable input, whereby a logical high closes a switch connecting the clock line of the programming shift register to the clock 1341 to receive clock pulses. The clock enable input 1343 is also connected to one input of a programming output AND gate 1350, the other input of the AND gate 1350 being connected to the output of the last flip flop in the programming shift register 1330. The first flip flop of the programming shift register constitutes the data input 1307 of the set of program storage elements. It will be appreciated that the operational unit may comprise any number of LUTs, that these LUTs may have any number of inputs, and that regardless of the number of inputs, the LUTs may have a plurality of outputs, some or all of which may be associated with LUT flip flops. As described above, when the multiplexer 1313 (and 1314) receives a suitable select input the two LUT flips flops 1315, 1316 (referred to as a test mode) constitute a LUT shift register. This shift register may comprise any number of LUT flip flops, including a flip flops in different operational units. Any of the various configurations described with regard to the foregoing embodiments are equally adaptable to the arrangement of figure 14.

In operation, this arrangement supports a method of testing an FPGA as described below

There is provided a method of operating an FPGA comprising the following steps. The method starts by of instructing a multiplexer having an output coupled to a set of program storage elements 1330 to select an input 381 receiving configuration values implementing a test protocol.

At the next step a plurality of LUT are instructed flip flops 1321, 1322 to enter an test configuration wherein each said LUT flip flop receives inputs implementing said test protocol, and wherein said LUT flip flops are connected as a LUT shift register.

At the next step, the programming set of program storage elements1330 is clocked to load a first set of elements thereof with LUT configuration values belonging to said configuration values implementing said test protocol; and clocking said programming shift register to load a second set of elements of said shift register with routing switch Configuration belonging to the configuration values implementing the test protocol.

It will be understood that the first set program storage elements and second set program storage elements may be interspersed in the same shift register. Loading values into the shift register will involve clocking the shift register to move the relevant configuration values to their desired final position. In some cases it may be necessary to address the shift register to which values are to be loaded. It may be desirable to load values into a plurality of shift registers in parallel or in series, in which case the method may iterate between a plurality of shift registers before proceeding to the next step.

At the next step the plurality of LUT flip flops 1321, 1322 are instructed to enter an operational configuration wherein each said LUT flip flop 1321, 1222 receives inputs from the outputs of a plurality of LUTs respectively.

At the next step data values are applied to the plurality of LUTs (on inputs 1320).

At the next step, the LUT flip flops are clocked to sample the outputs of each said LUT into a respective said flip flop, said outputs being responsive to said test protocol and said data inputs.

At the next step the LUT flip flops are instructed to enter a test configuration in which said LUT flip flops are connected in a LUT shift register, and connected as a shift register, and

At the next step the LUT flip-flops are clocked to read out the values of said LUT shift register comprising said outputs of said LUTs responsive to said test protocol and said data inputs, and the method then terminates.

Once test values are loaded, the behaviour of the FPGA will be assessed to confirm compliance with expectations. The details of this test procedure will depend on the nature of the FPGA system itself and are outside the scope of the present invention.

Generally speaking, the test mode described above is only used in a factory setting, to ensure that the FPGA is fully functional after manufacture.

In some embodiments, a plurality of test protocols may be defined, in which case the forgoing steps may be iterated a plurality of times, each iteration loading a different test protocol in sequence.

In operation, the arrangement of figure 14 supports a further method of operating an FPGA.

There is provided a method of operating an FPGA comprising the following steps. The method first instructs a multiplexer having an output coupled to a programming program storage elements to select an input receiving configuration values implementing a logic function.

At the next step a plurality of LUT flip flops are instructed to enter an operational configuration wherein each said LUT flip flop receives inputs from the outputs of a plurality of LUTs respectively.

At the next step the set of program storage elements are programmed to load a first set of elements thereof with LUT Configuration values belonging to the configuration values implementing the logic function; and clocking the set of program storage elements to load a second set of elements of the program storage elements with routing switch configuration belonging to said configuration values implementing said logic function, and the method then terminates.

The program storage elements may be configured as one or more shift registers.

The method may comprise the additional steps of enabling the output of a first programming shift register from a plurality of programming shift registers, implementing the steps of figure 12 with respect to the first programming shift register, and then repeating these steps for each of said plurality of shift registers.

There is provided a still further method of operating an FPGA comprising the following steps. The method first clocks the first programming shift register to read out a first set of elements thereof with said LUT Configuration values implementing a logic function and clocking said first programming shift register to read out a second set of elements of said shift register with routing switch Configuration implementing a logic function. The method then proceeds to compare the LUT Configuration implementing a logic function and routing switch Configuration implementing a logic function as read out of the shift register with a LUT Configuration implementing a logic function and routing switch Configuration implementing a logic function as originally read into said shift register, for example in accordance with the method described above. The method then terminates.

In ordinary circumstances, it is expected that the bitstream loaded into the shift register should be identical to that read from the shift register. In a case where the two are found to be identical the operational state of the FPGA, and the corresponding results can be deemed to be verified. In a case where the bitstream loaded into the shift register is not identical to that read from the shift register, some or all of the result must be considered to be unsound.

In accordance with certain embodiments there is provided a multiple tiered programming structure is provided for the memory cells determining the operation of a FPGA, where a first tier comprising ashift register is loaded with the program, whereby each flip flop in the shift register passes its value on to a respective coupling device (which may also be a flip flop). The coupling devices are then clocked in synchrony to provide the values to the memory cells. This makes it possible to easily refresh the memory cells. In some embodiments a plurality of sets of coupling devices may be provided, and the memory cell can be loaded with the value from a selected one of these coupling devices, or indeed directly from the shift register. A mechanism may be provided for reading back from the coupling devices into the shift register so as to read out the values of the coupling devices for validation of the FPGA results.

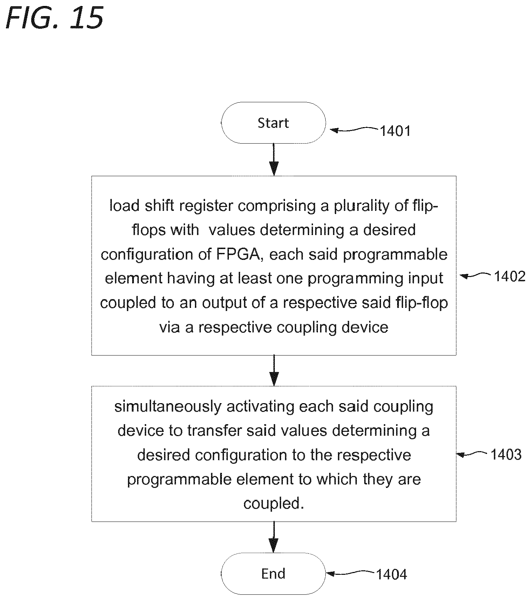

Figure 15 shows a method of programming a Field Programmable Gate Array comprising a plurality of programmable elements in accordance with an embodiment.

As shown the method starts at step 1401 before proceeding to step 1402 at which a shift register comprising a plurality of flip-flops is loaded with values determining a desired configuration of the FPGA, each programmable element having at least one programming input coupled to an output of a respective said flip-flop via a respective coupling device.

The method next proceeds to step 1403 at which each coupling device is simultaneously activated to transfer the values determining a desired configuration to the respective programmable element to which they are coupled.

It will be appreciated that different combinations of the steps described above may be envisaged. In many cases some or all of the method steps may be implemented by means of a computer programming, interfacing with the FPGA and providing suitable bitstreams as described above during the test, operational and verification modes of operation. In some cases some or all of this functionality may be implemented on the same chip as the FPGA, or be performed by part of a larger system to which the FPGA belongs. In other cases, this functionality may be provided by a test or verification system to which the FPGA is temporarily coupled for the purposes of testing after manufacture, or verification after generating suspicious results or exposure to error inducing conditions.

In some embodiments, the methods and processes described herein may be implemented in whole or part by a computing device. These methods and processes may be implemented by means of computer-application programs or services, an application-programming interface (API), a library, and/or other computer-program product, or any combination of such entities, for example as set out in further detail below. Where this is the case, embodiments may take the form of a computer readable medium bearing the program. Similarly, embodiments may take the form of a signal or data structure representing the program.

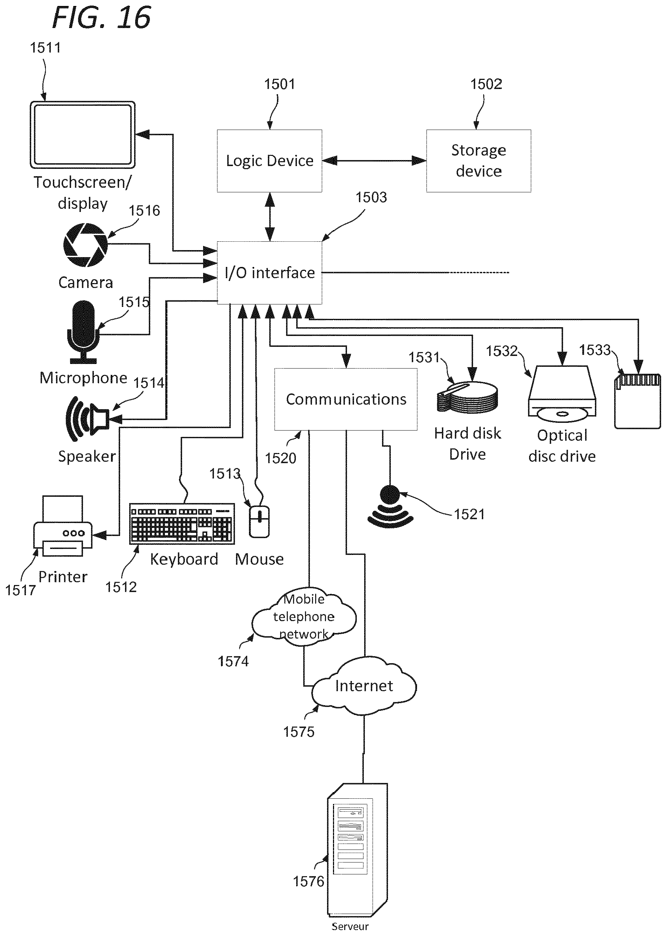

Figure 16 shows a generic computing system suitable for implementation of embodiments of the invention.

A shown in figure 16, a system includes a logic device 1501 and a storage device 1502. The system may optionally include a display subsystem 1511, input subsystem 1512, 1513, 1515, communication subsystem 1520, and/or other components not shown.

Logic device 1501 includes one or more physical devices configured to execute instructions. For example, the logic device 1501 may be configured to execute instructions that are part of one or more applications, services, programs, routines, libraries, objects, components, data structures, or other logical constructs. Such instructions may be implemented to perform a task, implement a data type, transform the state of one or more components, achieve a technical effect, or otherwise arrive at a desired result.

The logic device 1501 may include one or more processors configured to execute software instructions. Additionally or alternatively, the logic device may include one or more hardware or firmware logic devices configured to execute hardware or firmware instructions. Processors of the logic device may be single-core or multi-core, and the instructions executed thereon may be configured for sequential, parallel, and/or distributed processing. Individual components of the logic device 1501 optionally may be distributed among two or more separate devices, which may be remotely located and/or configured for coordinated processing. Aspects of the logic device 1501 may be virtualized and executed by remotely accessible, networked computing devices configured in a cloud-computing configuration.

Storage device 1502 includes one or more physical devices configured to hold instructions executable by the logic device to implement the methods and processes described herein. When such methods and processes are implemented, the state of storage 1502 device may be transformed-e.g., to hold different data.

Storage device 1502 may include removable and/or built-in devices. Storage device 1502 may comprise one or more types of storage device including optical memory (e.g., CD, DVD, HD-DVD, Blu-Ray Disc, etc.), semiconductor memory (e.g., RAM, EPROM, EEPROM, etc.), and/or magnetic memory (e.g., hard-disk drive, floppy-disk drive, tape drive, MRAM, etc.), among others. Storage device may include volatile, nonvolatile, dynamic, static, read/write, read-only, random-access, sequential-access, location-addressable, file-addressable, and/or content-addressable devices.

In certain arrangements, the system may comprise an interface 1503 adapted to support communications between the Logic device 1501 and further system components. For example, additional system components may comprise removable and/or built-in extended storage devices. Extended storage devices may comprise one or more types of storage device including optical memory 1532 (e.g., CD, DVD, HD-DVD, Blu-Ray Disc, etc.), semiconductor memory 1533 (e.g., RAM, EPROM, EEPROM, FLASH etc.), and/or magnetic memory 1531 (e.g., hard-disk drive, floppy-disk drive, tape drive, MRAM, etc.), among others. Such extended storage device may include volatile, nonvolatile, dynamic, static, read/write, read-only, random-access, sequential-access, location-addressable, file-addressable, and/or content-addressable devices.

It will be appreciated that storage device includes one or more physical devices, and excludes propagating signals as such. However, aspects of the instructions described herein alternatively may be propagated by a communication medium (e.g., an electromagnetic signal, an optical signal, etc.), as opposed to being stored on a storage device.

Aspects of logic device 1501 and storage device 1502 may be integrated together into one or more hardware-logic components. Such hardware-logic components may include field-programmable gate arrays (FPGAs), program- and application-specific integrated circuits (PASIC/ASICs), program- and application-specific standard products (PSSP/ASSPs), system-on-a-chip (SOC), and complex programmable logic devices (CPLDs), for example.

The term "program" may be used to describe an aspect of computing system implemented to perform a particular function. In some cases, a program may be instantiated via logic device executing machine-readable instructions held by storage device. It will be understood that different modules may be instantiated from the same application, service, code block, object, library, routine, API, function, etc. Likewise, the same program may be instantiated by different applications, services, code blocks, objects, routines, APIs, functions, etc. The term "program" may encompass individual or groups of executable files, data files, libraries, drivers, scripts, database records, etc.

In particular, the system of figure 16 may be used to implement embodiments of the invention.

For example a program implementing the steps described with respect to figure 15 may be stored in storage device 1502 and executed by logic device 1501. The bitstream loaded into the programming shift register or registers may be generated by the logic device 1501 and/or stored in storage device 1502 or the extended storage devices 1532, 1533 or 1531. The bitstream may be loaded into the programming shift register or registers by the action of the logic device 1501 via the communications interface 1520. The bitstream read from the shift register or registers may be retrieved by the action of the logic device 1501 via the communications interface 1520, and/or stored in storage device 1502 or the extended storage devices 1532, 1533 or 1531. The Logic device 1501 may retrieve the bitstream loaded to the shift register or registers, and the bitstream read from the shift register or registers in the verification mode, and perform a comparison to determine validity of results.

Accordingly the invention may be embodied in the form of a computer program.

It will be appreciated that a "service", as used herein, is an application program executable across multiple user sessions. A service may be available to one or more system components, programs, and/or other services. In some implementations, a service may run on one or more server-computing devices.

When included, display subsystem 1511 may be used to present a visual representation of data held by storage device. This visual representation may take the form of a graphical user interface (GUI). As the herein described methods and processes change the data held by the storage device 1502, and thus transform the state of the storage device 1502, the state of display subsystem 1511 may likewise be transformed to visually represent changes in the underlying data. Display subsystem 1511 may include one or more display devices utilizing virtually any type of technology. Such display devices may be combined with logic device and/or storage device in a shared enclosure, or such display devices may be peripheral display devices.

When included, input subsystem may comprise or interface with one or more user-input devices such as a keyboard 1512, mouse 1513, touch screen 1511, or game controller (not shown). In some embodiments, the input subsystem may comprise or interface with selected natural user input (NUI) componentry. Such componentry may be integrated or peripheral, and the transduction and/or processing of input actions may be handled on- or off-board. Example NUI componentry may include a microphone for speech and/or voice recognition; an infrared, color, stereoscopic, and/or depth camera for machine vision and/or gesture recognition; a head tracker, eye tracker, accelerometer, and/or gyroscope for motion detection and/or intent recognition; as well as electric-field sensing componentry for assessing brain activity.

When included, communication subsystem 1520 may be configured to communicatively couple computing system with one or more other computing devices. For example, communication module of may communicatively couple computing device to remote service hosted for example on a remote server 1576 via a network of any size including for example a personal area network, local area network, wide area network, or the internet. Communication subsystem may include wired and/or wireless communication devices compatible with one or more different communication protocols. As non-limiting examples, the communication subsystem may be configured for communication via a wireless telephone network 1574, or a wired or wireless local-or wide-area network. In some embodiments, the communication subsystem may allow computing system to send and/or receive messages to and/or from other devices via a network such as the Internet 1575. The communications subsystem may additionally support short range inductive communications 1521 with passive devices (NFC, RFID etc).

According to certain embodiments, configuration values for Lookup tables (LUTs) and programmable routing switches in an FPGA are provided by means of a number of flip flops arranges in a shift register. This shift register may receive test values in a factory test mode, and operational configuration values (implementing whatever functionality the client requires of the FPGA) in an operational mode. The bitstreams are provided at one end of the shift register, and clocked through until the last flip flop receives its value. Values may also be clocked out at the other end of the shift register to be compared to the initial bitstream in order to identify corruption of stored values e.g. due to radiation exposure. A clock gating architecture is proposed for loading data to or reading data from specific selected shift registers.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

## Claims

1. A Field Programmable Gate Array capable of implementing a logic function, said Field Programmable Gate Array comprising a plurality of programmable elements, said Field Programmable Gate Array **characterized by** further comprising:
a plurality of program storage elements, each said programmable element having at least one programming input coupled to an output of a respective said program storage element via a respective coupling device wherein each said coupling device comprises an activation input, and wherein the activation inputs of each said coupling device are ganged together,
and
wherein a value stored in each said program storage element determines the operation of the respective said programmable element, such that on activation of said activation input the values of said program storage elements are transferred via a respective said coupling device to determine the operation of the respective programmable element to which they are coupled.

2. The Field Programmable Gate Array of claim 1, wherein said plurality of program storage elements are flip flops arranged in a shift register.

3. The Field Programmable Gate Array of any preceding claim, said Field Programmable Gate Array being adapted to initiate said activation input at one or more predetermined instants.

4. The Field Programmable Gate Array of claim 3, said Field Programmable Gate Array being adapted to initiate said activation input at a plurality of predetermined instants so as to periodically refresh the values of each said programmable element.

5. The Field Programmable Gate Array of any preceding claim, said Field Programmable Gate Array being adapted to terminate said activation input a predetermined period after each initiation of said activation input.

6. The Field Programmable Gate Array of any preceding claim adapted to operate in a first mode wherein said program storage elements are loaded with predefined test values, and a second mode in which said program storage elements are loaded with values implementing said logic function.

7. The Field Programmable Gate Array of any preceding claim wherein one or more said coupling devices are flip-flops.

8. The Field Programmable Gate Array of any preceding claim wherein one or more said coupling devices are latches.

9. The Field Programmable Gate Array of any preceding claim wherein said program storage elements are flip-flops, said flip flops being configured as a shift register, and where said shift register is one of a plurality of such shift registers configured to supply different parts of said Field Programmable Gate Array.

10. The Field Programmable Gate Array of claim 9 further comprising an addressing system whereby any of said plurality of shift registers may be individually or by group addressed in order to be loaded with said predefined test values in said first mode or said values implementing said logic function in said second mode.

11. The Field Programmable Gate Array of any preceding claim wherein said program storage elements are flip-flops, said flip flops being configured as a shift register and each said flip-flop is coupled to the next said flip-flop in said shift register via a respective read-out multiplexer, each said read-out multiplexer receiving a further input from the output of the respective said coupling device via which a respective said programmable element is coupled to that said flip-flop, the selection inputs of each said read-out multiplexer being ganged together such that a first read-out signal value causes the values of each said coupling device to be read back into respective flip-flops of said shift register, and a second read-out signal value causes the value of each said flip-flop to pass to the next respective flip-flop of said shift register.

12. The Field Programmable Gate Array of any preceding claim wherein the output of each said program storage element is connected to a respective said programmable element via a data input of a respective programme selection multiplexer, each said programme selection multiplexer receiving a further data input from the output of the respective said coupling device via which a respective said programmable element is coupled to that said program storage element, the selection input of each said programme selection multiplexer being ganged together such that a first programme selection signal value causes the value of each said coupling device to be transferred to a respective said programmable element, and a second programme selection signal value causes the value of each said program storage element to be transferred to a respective said programmable element.

13. The Field Programmable Gate Array of any preceding claim wherein each said programmable element has at least one programming input coupled to an output of a respective said program storage element via a respective first said coupling device and a respective second said coupling device, and wherein said programme selection multiplexer receives a data input from the output of each of the respective said coupling devices via which a respective said programmable element is coupled to that said program storage element, the selection inputs of each said programme selection multiplexer being ganged together such that a first programme selection signal value causes the respective values of a first said coupling device coupled to each said programmable element to be transferred to that respective said programmable element, and a second programme selection signal value causes the respective values of second said coupling device coupled to each said programmable element to be transferred to that respective said programmable element.

14. The Field programmable gate array of claim 11 or 12 further adapted to toggle between said first program selection signal and said second program selection signal at predetermined intervals.

15. A method of programming a Field Programmable Gate Array comprising a plurality of programmable elements, said method comprising the steps of:
loading a plurality of program storage elements with values determining a desired configuration of said FPGA, each said programmable element having at least one programming input coupled to an output of a respective said program storage element via a respective coupling device, and
simultaneously activating each said coupling device to transfer said values determining a desired configuration to the respective programmable element to which they are coupled.

16. A computer program adapted to implement the steps of claim 15.
